# EUROPEAN PATENT SPECIFICATION

(11) **EP 3 297 056 B1**
(45) Date of publication and mention of the grant of the patent: **22.04.2020**
(21) Application number: 15894821.6
(22) Date of filing: 08.12.2015
(51) Int. Cl.: H01M 2/04, H01M 2/08, H01M 10/42, H01M 10/613, H05K 9/00

(54) **SECONDARY ELECTROCHEMICAL BATTERY WITH SEALER BODY AND PACKAGED CHIP SHIELDING STRUCTURE**
ELEKTROCHEMISCHE SEKUNDÄRBATTERIE MIT DICHTUNGSKÖRPER UND ABSCHIRMUNGSSTRUKTUR FÜR VERKAPSELTEN CHIP
PILE ÉLECTROCHIMIQUE RECHARGEABLE AVEC UN CORPS D'ÉTANCHÉITÉ ET UNE STRUCTURE DE BLINDAGE DE PUCE ENCAPSULÉE

(30) Priority: 12.06.2015 CN 201510321435; 12.06.2015 CN 201520404078 U
(43) Date of publication of application: 21.03.2018
(73) Proprietor: Fujian Nanping Nanfu Battery Co., Ltd., Nanping, Fujian 353000 (CN)
(72) Inventor: ZHANG, Qingshun, Nanping Fujian 353000 (CN); CHEN, Jintian, Nanping Fujian 353000 (CN); CHANG, Haitao, Nanping Fujian 353000 (CN)
(74) Representative: Gulde & Partner
(86) International application number: PCT/CN2015/096611
(87) International publication number: WO 2016/197566

(56) References cited:
- EP-A1- 1 026 761
- WO-A1-2015/039584
- CN-A- 101 425 609
- CN-A- 103 208 594
- CN-A- 104 900 820
- CN-U- 204 927 362
- JP-A- 2007 305 323
- US-A1- 2011 104 538

## Description

### TECHNICAL FIELD

The present invention relates to a secondary battery comprising a secondary electrochemical battery sealing body with a packaged chip heat dissipation structure.

### BACKGROUND

In recent years, secondary batteries (also known as rechargeable batteries) have been widely used in various portable electric devices and electronic devices such as toys and handheld devices. This has imposed an increasingly high requirement on energy storage of the secondary batteries. Lithium-ion secondary batteries have been increasingly applied in such fields due to their advantages such as high energy, capability of high-power discharge, and environmental friendliness.

During normal operation, the rechargeable batteries often have to cooperate with integrated circuit chips with other functions to achieve desirable operation effects. Usually, the rechargeable batteries are packaged isolately from the integrated circuit chips and then connected with them for use in combination through circuit boards and wires. Such products include a large number of peripheral components, require many manufacture processes, and are high in cost. Also, the rechargeable batteries and the integrated circuit chips are large in volume and relatively poor in performance, which are not beneficial for the miniaturization and microminiaturization.

In packaging the lithium-ion secondary batteries, each component of the lithium-ion secondary batteries occupies a relatively fixed space. A positive electrode tab, an isolation diaphragm, and a negative electrode tab are arranged inside a polymer battery cell, and one end of the positive electrode tab, facing away from the isolation diaphragm, is packaged by a battery cell top seal of a predefined height. As the battery cell top seal occupies a certain height of the polymer battery cell, the usable space inside the polymer battery cell is reduced. The space utilization of the polymer battery cell is substantially related to the energy density and capacity of the lithium-ion secondary batteries. Generally, the larger the space utilization of the polymer battery cell is, the higher the energy density and capacity of the lithium-ion secondary battery are. Therefore, existing lithium-ion secondary batteries all suffer from the problems of relatively low energy density and capacity due to low space utilization of the polymer battery cell.

For example, a patent document US 2011/104538 A1 discloses a cap assembly including a safety vent, a printed circuit board, a thermo device acting as a PTC, a cap-up, and a gasket. And another patent document EP 1026761 A1 a sealing member 200 for a secondary battery. The sealing member comprises a metal ring, a flexible substrate carrying an electronic circuit and a terminal cap soldered to the circuit board. The assembly is secured by caulking the peripheral portions of sealing bottom plate and inner gasket. In addition, a patent document JP 2007 305323 A discloses a battery comprising a printed wiring board housed in a battery case, underneath an electrode cap. The cap is connected to the circuit board through a plurality of legs. A resin ring washer is fitted over the battery lid to seal the battery. In addition, a patent document WO 2015/039584 A1 disclose a rechargeable lithium ion battery comprising a battery sealing body sealing an opening portion of a battery case provided with a loop line, and a battery cell disposed within the battery case. The battery sealing body comprises electrode cap, circuit board and insulating washer. The electrode cap is soldered onto and in electrical contact with the circuit substrate of the printed circuit board, thus forming a fist enclosed electromagnetic shielding space. However, each of the above disclosed documents has some disadvantages.

### SUMMARY

The present invention, which is defined by the appended claims, provides a secondary electrochemical battery having a sealing body with a packaged chip shielding structure, which is used for sealing an opening portion of a battery case of a secondary electrochemical battery, wherein the sealing body includes a negative electrode cap, a circuit board module and an insulating washer, the battery case has a recessed loop line structure at one end thereof adjacent to the negative electrode cap; the circuit board module is located between a loop line and the negative electrode cap, and a plurality of electronic components for generating electromagnetic radiation during operation are arranged on the circuit board module, the diameter of the circuit board module is sized to be between an inner diameter of a recess composed by the loop line and an inner diameter of the battery case, so that the circuit board module may be clamped in one side of the loop line for sealing the opening portion of the battery case; the circuit board module and the negative electrode cap are connected through an electrically-conductive material, the negative electrode cap and the circuit board module constitute a first enclosed electromagnetic shielding space, the battery case and the circuit board module constitute a second enclosed electromagnetic shielding space, and the electronic components are arranged within the first enclosed electromagnetic shielding space and the second enclosed electromagnetic shielding space; the insulating washer has a " 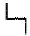 "-shaped section, and disposed within gaps of the battery case, the circuit board module and the negative electrode cap, so as to press and fix the circuit board module between the loop line and the battery case, and isolate the battery case from the negative electrode cap.

Clamp protrusions corresponding to clamp slots are provided at the edge of the negative electrode cap, for fixing the negative electrode cap on the circuit board module.

Preferably, the negative electrode cap is made of an electrically-conductive material.

A metal ring is arranged on a contact part between the circuit board component and the negative electrode cap, the clamp slots are provided within the metal ring, and the metal ring is in conductive contact with the clamp slots, so as to constitute an enclosed electromagnetic shielding space with the negative electrode cap.

Preferably, the insulating washer is a flexible and elastic annular insulating padding layer. Preferably, one segment of the 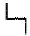 -shaped insulating washer is used to press and fix the circuit board module between the loop line and the battery case, and the other segment is used to isolate the battery case from the negative electrode cap.

Preferably, the loop line has a recess depth of 0.2 mm to 1.2 mm relative to the surface of the battery case.

The sealing body is used to seal an opening portion of a battery case of the secondary electrochemical battery, and the battery further includes a battery cell and a positive electrode cap, the positive electrode cap is connected to the battery case so as to constitute a positive electrode of the secondary battery; the battery cell is disposed within the battery case, and located between the positive electrode cap and the loop line structure.

A electrochemical battery sealing body according to the present invention has a cleverly and reasonably designed structure in that a sealing region of the electrochemical battery electrode has an electrode cap which can cooperate with a circuit board to form a shielding structure capable of preventing high frequency components inside it from causing interference to an external environment and conducting heat generated by the circuit board during its operation to the external environment, thereby playing a role of protecting the circuit board and the components. Further, a loop line structure is arranged on the battery case between the battery cell and the circuit board to position the battery cell and the circuit board relative to each other, and to cooperate with the insulating washer between the electrode cap and the battery case to fix the circuit board without any soldering.

### BRIEF DESCRIPTION OF DRAWINGS

Further objects, functions, and advantages of the present invention shall become apparent from the following description of embodiments of the present invention with reference to accompanying drawings, wherein
FIG. 1a schematically shows a structural schematic view showing an electrochemical battery according to the present invention.
FIG. 1b is an exploded perspective view showing an electrochemical battery according to the present invention.
FIG. 1c is a cross-sectional view of FIG. 1a taken along a line A-A.
FIG. Id is a circuit schematic view showing a circuit board module according to the present invention.
FIG. 2a schematically shows an exploded perspective structural schematic view showing an electrochemical battery sealing body 200 for the secondary electrochemical battery.
FIG. 2b schematically shows an enlarged partial cross-sectional view showing an electrochemical battery sealing body 200.
FIG. 3 is an exploded perspective view showing a sealing body 300 for an electrochemical battery according to an embodiment of the present invention.
FIG. 4 is a structural schematic view showing another embodiment of a second printed circuit board according to an embodiment of the present invention.
FIG. 5a is a structural schematic view showing a shielding structure according to an embodiment not forming part of the present invention.
FIG. 5b is an enlarged partial structural schematic view of FIG. 5a.

### DETAILED DESCRIPTION

With reference to exemplary embodiments, objects and functions of the present invention as well as methods for achieving them shall be explained. However, the present invention is not to be limited by the exemplary embodiments disclosed below, but can be realized in various forms. The specification is intended in nature solely to provide a thorough understanding of specific details of the present invention to those skilled in the art.

It should be understood that the general description above and detailed description below are only exemplarily explanative and illustrative, and shall not be understood as limitations on the protection scope claimed by the present invention.

In the following, embodiments of the present invention will be described with reference to the accompanying drawings. In the accompanying drawings, like reference numerals refer to like or similar parts, or like or similar steps.

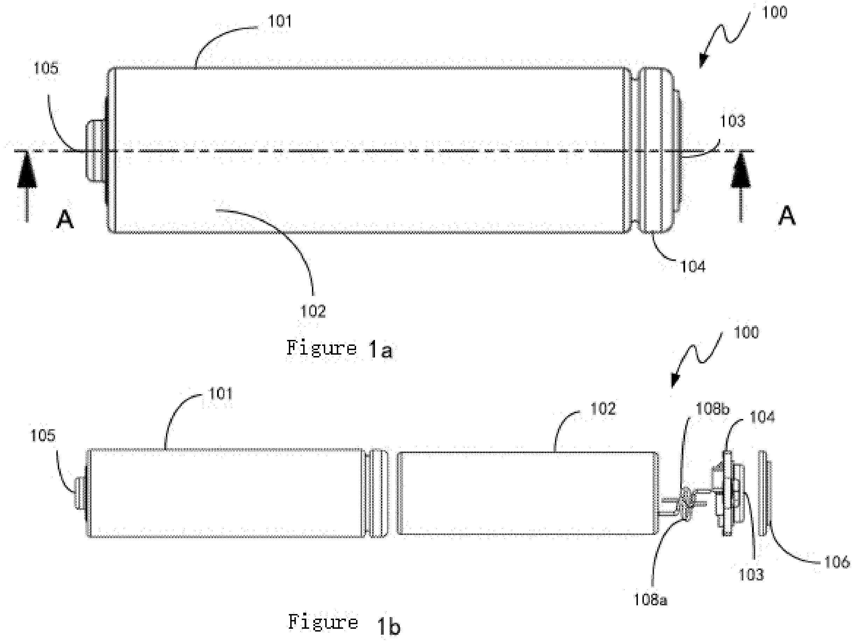

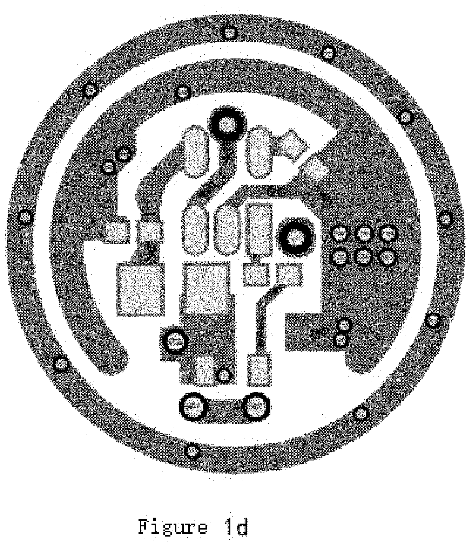

The present invention provides a secondary electrochemical battery. FIG. 1a and FIG. 1b are a structural schematic view and an exploded perspective view of an electrochemical battery according to the present invention, respectively. As shown in FIG. 1a and FIG. 1b, an electrochemical battery 100 includes a battery case 101, a battery cell 102 disposed within the battery case 101, a negative electrode cap 103, a circuit board module 104 disposed in the space between the battery cell 102 and the negative electrode cap 103, and a positive electrode cap 105. The negative electrode cap of the present invention has functions of electromagnetic shielding, electrostatic shielding and heat dissipation. The battery cell 102 is housed in the battery case 101. The battery case 101 is a steel case with a cylinder or cuboid shaped structure for outputting a positive electrode and fixing the circuit board module 104. According to one embodiment of the present invention, the positive electrode cap 105 is rotated to the right so as to be integrally formed with the battery case 101.

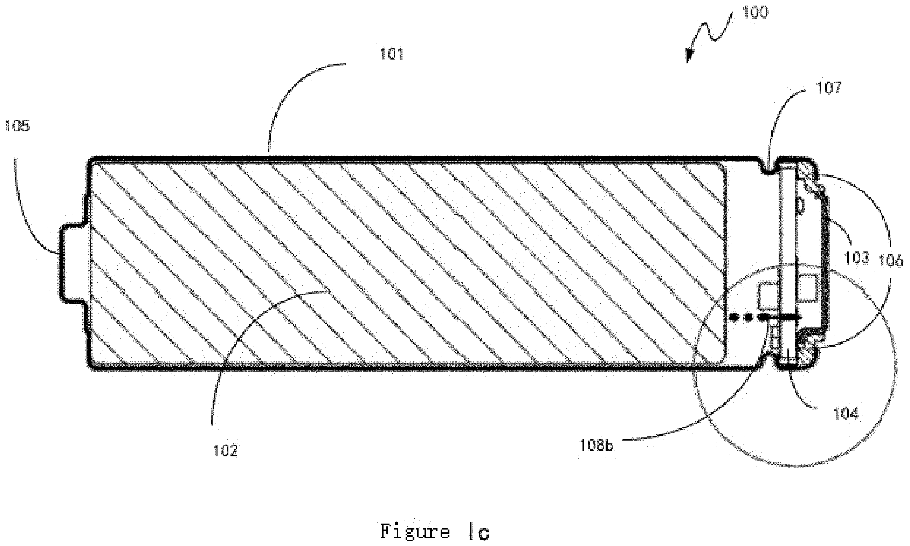

The circuit board module 104 is at least one layer of printed circuit boards (PCBs) with a first side and a second side, wherein the first side is directed towards the negative electrode cap 103 relative to the electrochemical battery 100, and the second side is directed towards the battery cell 102 relative to the electrochemical battery 100. The PCB is a circuit board having a wiring pattern printed thereon (as shown in FIG. Id) and is of a size substantially corresponding to an inner diameter of the case for the battery 100. A plurality of printed wires and components are arranged on the first side or second side of the circuit board module 104. The circuit board module 104 is in proximity to the side of the negative electrode cap 103 of the battery 100 and positioned between the battery cell 102 and the negative electrode cap 103. A connector is provided on the circuit board module 104 for fixing the negative electrode cap 103 onto the circuit board module 104. For example, the negative electrode cap 103 may be fixed onto the circuit board module 104 by means of clamping. The circuit board module is configured to perform charging protection and charging indication on the lithium battery as well as discharge protection, short circuit protection, over discharge protection, and output voltage control on the battery. Electrode connecting wires 108a and 108b are provided between the circuit module 104 and the battery cell 102 for leading the positive electrode and a negative electrode out of the battery, respectively. The connecting wire for the positive electrode is denoted as 108a and the connecting wire for the negative electrode is denoted as 108b. FIG. 1c is a sectional view taken along a line A-A in FIG. 1a. Insulating washers 106 are provided between the circuit board module 104 and the battery case 101 outside, and between the negative electrode cap 103 and the battery case 101. Each of the insulating washers 106 is a flexible and elastic annular insulating padding layer and has a 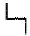 -shaped section along the line A-A of the electrochemical battery 101. The insulating washers 106 can play a role of isolating the battery case 101 that serves as a first electrode from the negative electrode cap 103 that serves as a second electrode, and can press and fix the circuit board module 104 due to the elasticity of the insulating padding layer 106 to seal the gap between the battery case 101 and the negative electrode cap 103. Particularly, as shown in FIG. 1c, one segment of the 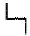 shape is used to press and fix the circuit board module 104 between the loop line 107 and the battery case 101, and the other segment of the 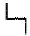 shape is used to isolate the battery case 101 from the negative electrode cap 103.

A loop line 107 is formed as an annular inward recess on an outer surface, corresponding to a location between the battery cell 102 and the printed circuit board 106, of the battery case 101. The battery cell 102 is arranged within the battery case 101 and positioned between the positive electrode cap 105 and the loop line 107 structure. The insulating washer 106 and the loop line 107 are arranged in such a manner that the circuit board module 104 is fixed between the annular recess of the battery case 101 and the bottom of the battery case 101. Therefore, the battery case 101 and the negative electrode cap 103 are connected without any soldering.

The loop line 107 structure is configured to position the circuit board module 104. Particularly, the circuit board module 104 is configured with the diameter thereof being sized between an inner diameter of the annular recess constituted by the loop line 107 and an inner diameter of the battery case 101. When the battery is assembled, the battery cell 102 is arranged in the battery case 101; then the circuit board module 104 is assembled into the battery case 101, the circuit board module 104 is sized so that it can be engaged onto the loop line 107 structure, thereby avoiding being in contact with the battery cell 102; and then the battery case 101 is isolated from the negative electrode cap 103 through the insulating padding layer 106. As such, the assembly of the battery 100 is completed. Such a structure allows the circuit board module 104 to form an enclosed space inside the battery case 101 for accommodating the battery cell 102 by means of the loop line 107 structure, therefore the volume of the battery cell 102 and thus the capacity of the secondary battery can be increased. Preferably, the battery cell 102 has a sealed structure and can be operated by leading a positive electrode and a negative electrode of the battery cell 102 out of the battery cell 102 so as to be connected to the positive electrode and the negative electrode of the battery respectively.

Preferably, the loop line 107 has a recess depth of 0.2 mm to 1.2 mm relative to the surface of the battery case 101.

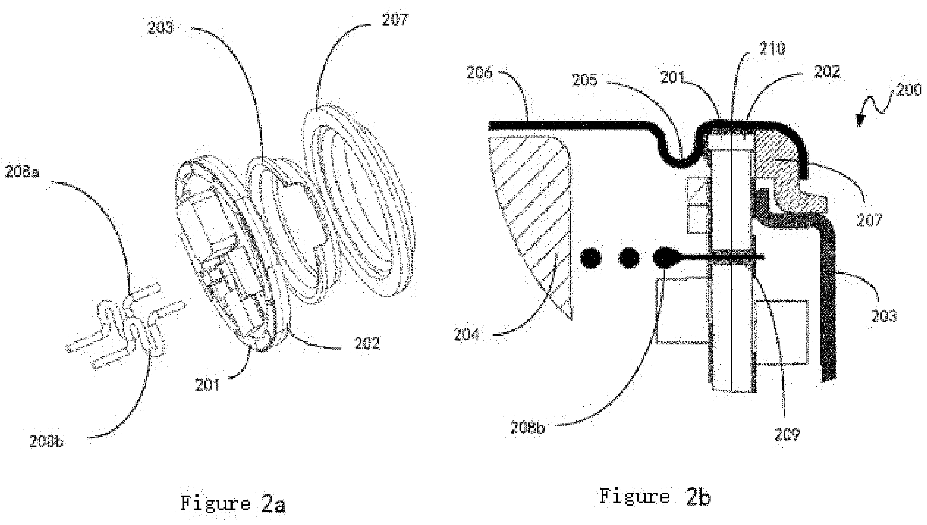

FIG. 2a shows schematically an exploded perspective structural view showing a sealing body 200 for an electrochemical battery according to a first embodiment of a secondary electrochemical battery of the present invention. FIG. 2b shows schematically a partial enlarged sectional view showing a sealing body 200 for an electrochemical battery according to a first embodiment of the present invention. As shown in FIG. 2a and FIG. 2b, the sealing body 200 includes a first PCB 201, a second PCB 202, a negative electrode cap 203, and insulating washers 207 arranged between the second PCB 202 and the battery case 206 and between an exterior portion of the negative electrode cap and the battery case 206. According to one embodiment of the present invention, the first PCB 201 and the second PCB 202 are two printed circuit boards of the same area. The first PCB 201 is close to the battery cell 204, and the second PCB 202 is far away from the battery cell 204. The first PCB 201 is engaged onto the battery case 206 through the loop line 205. The second PCB 202 and the negative electrode cap 203 are electrically connected through contact and constitute a shielding structure. A plurality of chips or circuit components are arranged on one side of the first PCB 201 in proximity to the battery cell 204 and one side of the second PCB 202 far away from the battery cell 204, wherein components generating radiations during operation are arranged in a shielding structure constituted by the second PCB 202 and the negative electrode cap 203. The insulating washers 207 are arranged between the second PCB 202 and the battery case 206 and between an exterior portion of the negative electrode cap 203 and the battery case 206. Each of the insulating washers 207 is a flexible annular insulating padding layer that can press and fix the first PCB 201 and the second PCB 202 onto the loop line 205 in order to seal the gap between the battery case 206 and the negative electrode cap 203. A tin coating 210 for enhancing contact is applied at places where the battery case 206 is in contact with the first PCB and the second PCB, in order to seal the gap between the circuit board and the battery case. By means of a through hole 209 between the first PCB and the second PCB, a negative electrode connecting wire 208b (and a positive electrode connecting wire denoted as 208a, which is not shown in the figure) led out of the battery cell 204 is connected with the wires on the first PCB and the second PCB. An electrically-conductive material such as a copper coating is coated on the inner surface of the through hole 209 such that the wiring of a plurality of circuit boards can be connected by means of the through hole 209 and connected to a place where the negative electrode cap is in contact with the circuit board, thereby conducting it to the negative electrode cap.

A large number of electronic components are integrated on the circuit board module of the secondary electrochemical battery according to the present invention, with a relatively integration degree, some electronic components, such as inductive coils, may generate electromagnetic radiation during operation, therefore when the secondary electrochemical battery is used, these electronic components may generate the electromagnetic radiation to affect electronic devices using these batteries. For example, when a battery is used on the electronic devices, such as a loudspeaker, the electromagnetic radiation generated by the electronic components of the battery itself may interfere the loudspeaker itself if not shielded, resulting in an undesired squealing noise and affecting the effect of using the electronic devices. The sealing body 200 according to the present invention may achieve a purpose of effectively shielding the electromagnetic radiation generated by the electronic components on the PCB by means of the arranged special structure.

In particular, according to one embodiment of the present invention, clamp slots are arranged on another side of the PCB board relative to the loop line 205, that is, on one side of the second PCB 202 facing the negative electrode cap 203 as shown in FIG. 2a and 2b, for clamping and fixing the negative electrode cap 203. In order to achieve good electromagnetic radiation shielding, the shape of the clamp slot should correspond to a shape of the edge of the negative electrode cap 203. For example, if the battery is a cylindrical battery, the negative electrode cap 203 is of a circular shape, then the clamp slot should be of an annular shape corresponding to the circular shape. If the negative electrode cap 203 is of a rectangular shape, then the clamp slot should be of a rectangular shape corresponding to the rectangular shape. One region, surrounded by the clamp slot, of the circuit board module constitutes an enclosed space jointly with the negative electrode cap 203, the electronic component (such as an inductor) generating the electromagnetic radiation is arranged within the enclosed space on one side of the circuit board module facing the negative electrode cap 203, which may effectively shield the electromagnetic radiation generated by the electronic component, and thus may eliminate the electromagnetic interference influences of the electronic devices using the batteries. An electrically-conductive material layer, such as a metal plating layer, is provided on the inner wall (namely, a contact surface with the negative electrode cap 203) of the clamp slot, for being in conductive contact with the negative electrode cap 203, thereby constituting an enclosed electromagnetic radiation space.

The negative electrode cap 203 is preferably made of an electrically-conductive material, so as to effectively shield the electromagnetic radiation generated by the electronic components. For example, the negative electrode cap 203 is made of a metal.

It is to be understood by those skilled in the art that the sealing body 200, as shown in FIG. 2a and 2b, including two PCBs, is only illustrative, and the sealing body of the present invention is also applicable to one PCB or a combination of multiple layers of PCBs.

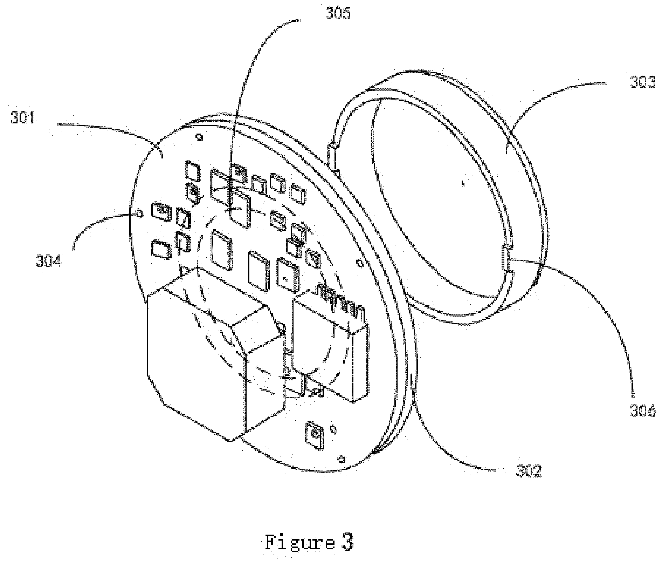

FIG.3 is an exploded perspective view showing a sealing body 300 for an electrochemical battery according to an embodiment of the present invention. The sealing body 300 includes a first PCB 301, a second PCB 302, and a negative electrode cap 303, wherein the first PCB 301 and the second PCB 302 have a plurality of circuit components arranged thereon. A plurality of small holes 304 are provided on edges of the first PCB 301 and the second PCB 302 for fixing the first PCB 301 and the second PCB 302 together. According to one embodiment of the present invention, one side, which is connected to the negative electrode cap 303, of the second PCB 302 has clamp slots 305 (shown in a dashed line in the figure) at locations corresponding to the edge of the negative electrode cap 303, and the edge of the negative electrode cap 303 has clamp protrusions 306 corresponding to the clamp slots 305 for fixing the negative electrode cap 303 onto the second PCB 302 and for realizing electrical connection to form an enclosed electromagnetic shielding space.

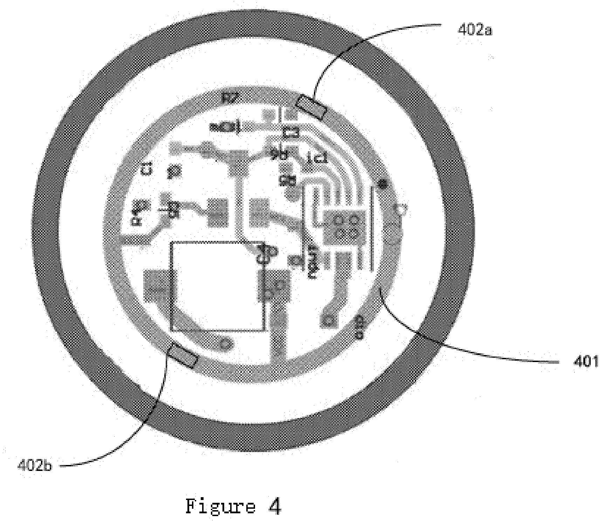

FIG. 4 shows an electromagnetic shielding structure according to an embodiment of the present invention. As shown in FIG. 4, clamp slots 402 are provided on one side, which is adjacent to the negative electrode cap 303, of the second PCB 302, and FIG. 4 illustrates two opposite clamp slots 402a and 402b. A metal ring 401 is arranged on a contact part between the second PCB 302 and the negative electrode cap 303, the clamp slots 402a and 402b are provided within the metal ring 401, and the metal ring 401 is in conductive contact with the clamp slots 402a and 402b, and metal layers, being in conductive contact with the metal ring 401, are provided on the inner walls of the clamp slots 402a and 402b. After being engaged onto the second PCB 302 through the clamp slots 402, the negative electrode cap 303 is in contact with the metal ring 401 by means of the clamp slots 402, so as to cooperate to function as an electromagnetic shielding shroud. The negative electrode cap 303 is made of a metal.

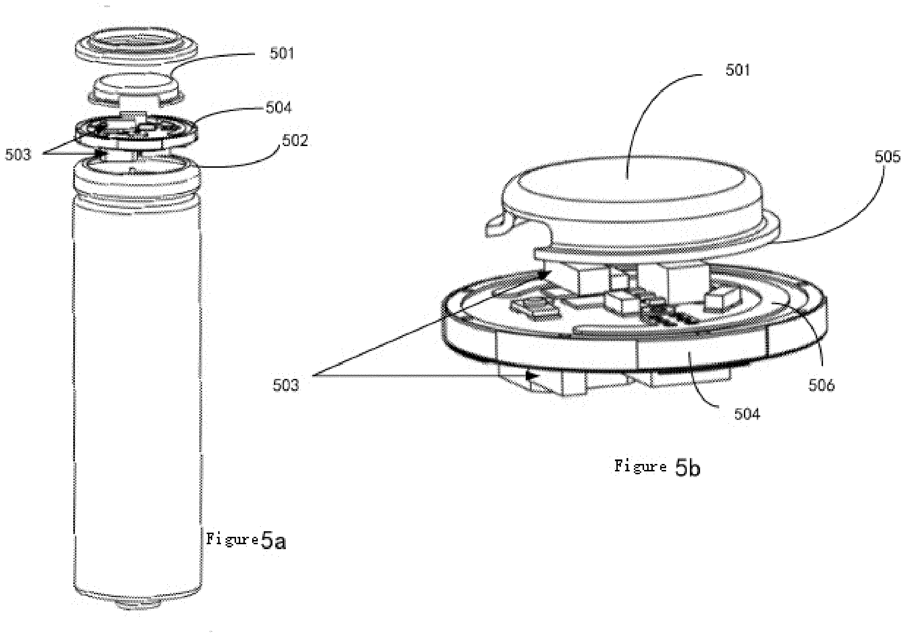

FIG. 5a is a schematic view showing a shielding structure of a battery sealing body according to an embodiment not forming part of the present invention. As shown in FIG. 5a, the negative electrode cap 501 and the battery housing 502 are arranged on two sides of the circuit board 504, and the two both are enclosed metallic cases, the negative electrode cap 501 and the circuit board module 504 constitute a first enclosed electromagnetic shielding space, the battery case 502 and the circuit board module 504 constitute a second enclosed electromagnetic shielding space, and the two enclosed electromagnetic shielding spaces may excellently enclose the electromagnetic interference generated by the circuit on external electric appliances, and excellently shield the damage of external static electricity on the electronic components 503 on an internal circuit of the battery. FIG. 5b is an enlarged schematic view showing the shielding structure of the battery sealing body. As shown in FIG. 5b, the negative electrode cap 501 is welded on the circuit board 504, and a position of a circuit negative electrode output terminal on the circuit board 504 is a soldering part 506 of the negative electrode cap 501 and the circuit board 504, so that the same wire is used for negative electrode output and circuit grounding, and the induced electricity generated by the high-frequency electronic components 503 goes back to the ground and cannot be transmitted to the outside. Preferably, the soldering part 506 is of a "C"-shaped annular structure.

A electrochemical battery sealing body according to the present invention has a cleverly and reasonably designed structure in that a sealing region of the electrochemical battery electrode has an electrode cap which can cooperate with a circuit board to form a shielding structure capable of preventing high frequency components inside it from causing interference to an external environment and conducting heat generated by the circuit board during its operation to the external environment, thereby playing a role of protecting the circuit board and the components. Further, a loop line structure is arranged on the battery case between the battery cell and the circuit board to position the battery cell and the circuit board relative to each other, and to cooperate with the insulating washer between the electrode cap and the battery case to fix the circuit board without any soldering.

Other embodiments of the present invention can readily occur to and be understood by those skilled in the art in light of the description and practice of the present invention disclosed herein. Such description and embodiments are solely meant to be illustrative and the true scope of the present invention is defined by the claims.

## Claims

1. A secondary electrochemical battery (100, 200), comprising
a battery case (101, 206) with a recessed loop line structure (107, 205) at one end thereof adjacent to a negative electrode cap (103, 203, 303),
a positive electrode cap (105) connected to the battery case (101, 206) so as to constitute a positive electrode of the secondary battery (100),
a battery cell (102, 204) disposed within the battery case (101, 206) and located between the positive electrode cap (105) and the recessed loop line structure (107, 205),
a secondary electrochemical battery sealing body (200, 300, 400) with a packaged chip shielding structure, which is used for sealing an opening portion of the battery case (101, 206),
wherein the sealing body (200, 300, 400) comprises the negative electrode cap (103, 203, 303), a circuit board module (104, 201, 202, 301, 302) and an insulating washer (106, 207),
the circuit board module (104, 201, 202, 301, 302) is located between the recessed loop line structure (107, 205) and the negative electrode cap (103, 203, 303), and a plurality of electronic components for generating electromagnetic radiation during operation are arranged on the circuit board module (104, 201, 202, 301, 302), the diameter of the circuit board module is sized to be between an inner diameter of a recess composed by the recessed loop line structure (107, 205) and an inner diameter of the battery case, so that the circuit board module may be clamped in one side of the recessed loop line structure (107, 205) for sealing the opening portion of the battery case (101, 206); the circuit board module (104, 201, 202, 301, 302) and the negative electrode cap (103, 203, 303) are connected through an electrically-conductive material, the negative electrode cap (103, 203, 303) and the circuit board module (104, 201, 202, 301, 302) constitute a first enclosed electromagnetic shielding space, the battery case (101, 206) and the circuit board module (104, 201, 202, 301, 302) constitute a second enclosed electromagnetic shielding space, and the electronic components are arranged within the first enclosed electromagnetic shielding space and the second enclosed electromagnetic shielding space;
a metal ring (401) is arranged on a contact part between the circuit board module (104, 201, 202, 301, 302) and the negative electrode cap (103, 203, 303), clamp slots (305, 402) are provided within the metal ring (401), and the metal ring is in conductive contact with the clamp slots, so as to constitute an enclosed electromagnetic shielding space with the negative electrode cap; and
the insulating washer (106, 207) has a " 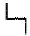 "-shaped section, and is disposed within gaps among the battery case, the circuit board module and the negative electrode cap, so as to press and fix the circuit board module between the recessed loop line structure (107, 205) and the battery case (101, 206), and isolate the battery case from the negative electrode cap,
wherein clamp protrusions (306) corresponding to the clamp slots (305, 402) are provided at the edge of the negative electrode cap, for fixing the negative electrode cap on the circuit board module.

2. The secondary electrochemical battery (100, 200) according to claim 1, wherein the negative electrode cap (103, 203, 303) is made of an electrically-conductive material.

3. The secondary electrochemical battery (100, 200) according to claim 1, wherein the insulating washer (106, 207) is a flexible and elastic annular insulating padding layer.

4. The secondary electrochemical battery (100, 200) according to claim 1, wherein one segment of the 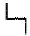 -shaped insulating washer (106, 207) is used to press and fix the circuit board module between the recessed loop line structure (107, 205) and the battery case (101, 206), and the other segment is used to isolate the battery case from the negative electrode cap.

## Patentansprüche

1. Elektrochemische Sekundärbatterie (100, 200), umfassend
ein Batteriegehäuse (101, 206) mit einer vertieften Ringlinienstruktur (107, 205) an einem Ende davon neben einer negativen Elektrodenkappe (103, 203, 303),
eine positive Elektrodenkappe (105), die mit dem Batteriegehäuse (101, 206) verbunden ist, um eine positive Elektrode der Sekundärbatterie (100) zu bilden,
eine Batteriezelle (102, 204), die in dem Batteriegehäuse (101, 206) angeordnet ist und sich zwischen der positiven Elektrodenkappe (105) und der vertieften Ringlinienstruktur (107, 205) befindet,
einen Dichtungskörper (200, 300, 400) für eine elektrochemische Sekundärbatterie mit einer Abschirmungsstruktur für einen verkapselten Chip, die dazu verwendet wird, einen Öffnungsabschnitt des Batteriegehäuses (101, 206) abzudichten,
wobei der Dichtungskörper (200, 300, 400) die negative Elektrodenkappe (103, 203, 303), eine Leiterplattenbaugruppe (104, 201, 202, 301, 302) und eine Isolierscheibe (106, 207) umfasst,
die Leiterplattenbaugruppe (104, 201, 202, 301, 302) sich zwischen der vertieften Ringlinienstruktur (107, 205) und der negativen Elektrodenkappe (103, 203, 303) befindet, und eine Mehrzahl elektronischer Komponenten zur Erzeugung elektromagnetischer Strahlung während des Betriebs auf der Leiterplattenbaugruppe (104, 201, 202, 301, 302) angeordnet sind, wobei der Durchmesser der Leiterplattenbaugruppe eine Größe besitzt, die zwischen dem inneren Durchmesser einer Vertiefung, die aus der vertieften Ringlinienstruktur (107, 205) besteht, und einem inneren Durchmesser des Batteriegehäuses liegt, sodass die Leiterplattenbaugruppe in eine Seite des vertieften Ringlinienstruktur (107, 205) eingeklemmt werden kann, um den Öffnungsabschnitt des Batteriegehäuses (101, 206) abzudichten; die Leiterplattenbaugruppe (104, 201, 202, 301, 302) und die negative Elektrodenkappe (103, 203, 303) miteinander durch ein elektrisch leitendes Material verbunden sind, wobei die negative Elektrodenkappe (103, 203, 303) und die Leiterplattenbaugruppe (104, 201, 202, 301, 302) einen ersten geschlossenen elektromagnetischen Abschirmungsraum bilden, das Batteriegehäuse (101, 206) und die Leiterplattenbaugruppe (104, 201, 202, 301, 302) einen zweiten geschlossenen elektromagnetischen Abschirmungsraum bilden, und die elektronischen Komponenten in dem ersten geschlossenen elektromagnetischen Abschirmungsraum und dem zweiten elektromagnetischen Abschirmungsraum angeordnet sind;
ein Metallring (401) auf einem Kontaktteil zwischen der Leiterplattenbaugruppe (104, 201, 202, 301, 302) und der negativen Elektrodenkappe (103, 203, 303) angeordnet ist, Klemmschlitze (305, 402) in dem Metallring (401) vorgesehen sind, und der Metallring in leitendem Kontakt mit den Klemmschlitzen steht, um mit der negativen Elektrodenkappe einen geschlossenen elektromagnetischen Abschirmungsraum zu bilden; und
die Isolierscheibe (106, 207) einen " 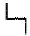 "-förmigen Abschnitt aufweist, und in Lücken zwischen dem Batteriegehäuse, der Leiterplattenbaugruppe und der negativen Elektrodenkappe angeordnet ist, um die Leiterplattenbaugruppe zwischen der vertieften Ringlinienstruktur (107, 205) und dem Batteriegehäuse (101, 206) zu pressen und zu fixieren, und das Batteriegehäuse von der negativen Elektrodenkappe zu isolieren,
wobei Klemmvorsprünge (306) entsprechend den Klemmschlitzen (305, 402) am Rand der negativen Elektrodenkappe zum Fixieren der negativen Elektrodenkappe auf der Leiterplattenbaugruppe vorgesehen sind.

2. Elektrochemische Sekundärbatterie (100, 200) nach Anspruch 1, wobei die negative Elektrodenkappe (103, 203, 303) aus einem elektrisch leitenden Material gefertigt ist.

3. Elektrochemische Sekundärbatterie (100, 200) nach Anspruch 1, wobei die Isolierscheibe (106, 207) eine flexible und elastische ringförmige isolierende Polsterschicht ist.

4. Elektrochemische Sekundärbatterie (100, 200) nach Anspruch 1, wobei ein Segment der 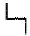 -förmigen Isolierscheibe (106, 207) verwendet wird, um die Leiterplattenbaugruppe zwischen der vertieften Ringlinienstruktur (107, 205) und das Batteriegehäuse (101, 206) zu pressen und zu fixieren, und das andere Segment verwendet wird, um das Batteriegehäuse von der negativen Elektrodenkappe zu isolieren.

## Revendications

1. Pile électrochimique secondaire (100, 200), comprenant
une enveloppe (101, 206) de pile avec une structure de ligne circulaire en retrait (107, 205) à une de ses extrémités adjacente à un capuchon (103, 203, 303) d'électrode négative,
un capuchon (105) d'électrode positive raccordé à l'enveloppe (101, 206) de pile de manière à former une électrode positive de la pile secondaire (100),
une cellule (102, 204) de pile disposée à l'intérieur de l'enveloppe (101, 206) de pile et positionnée entre le capuchon (105) d'électrode positive et la structure de ligne circulaire en retrait (107, 205),
un corps de scellement (200, 300, 400) de pile électrochimique secondaire avec une structure de blindage de puce encapsulée, utilisée pour sceller une partie d'ouverture de l'enveloppe (101, 206) de pile,
où le corps de scellement (200, 300, 400) comprend le capuchon (103, 203, 303) d'électrode négative, un module de circuit imprimé (104, 201, 202, 301, 302) et une rondelle isolante (106, 207),
le module de circuit imprimé (104, 201, 202, 301, 302) est positionné entre la structure de ligne circulaire en retrait (107, 205) et le capuchon (103, 203, 303) d'électrode négative, et une pluralité de composants électroniques pour la génération d'un rayonnement électromagnétique en cours de fonctionnement sont disposés sur le module de circuit imprimé (104, 201, 202, 301, 302), le diamètre du module de circuit imprimé est dimensionné de manière à être compris entre le diamètre intérieur d'un renfoncement formé par la structure de ligne circulaire en retrait (107, 205) et le diamètre intérieur de l'enveloppe de pile, de manière à permettre le serrage du module de circuit imprimé sur un côté de la structure de ligne circulaire en retrait (107, 205) pour le scellement de la partie d'ouverture de l'enveloppe (101, 206) de pile ; le module de circuit imprimé (104, 201, 202, 301, 302) et le capuchon (103, 203, 303) d'électrode négative sont raccordés par un matériau électriquement conducteur, le capuchon (103, 203, 303) d'électrode négative et le module de circuit imprimé (104, 201, 202, 301, 302) forment un premier espace de blindage électromagnétique hermétiquement clos, l'enveloppe (101, 206) de pile et le module de circuit imprimé (104, 201, 202, 301, 302) forment un deuxième espace de blindage électromagnétique hermétiquement clos, et les composants électroniques sont disposés à l'intérieur du premier espace de blindage électromagnétique hermétiquement clos et du deuxième espace de blindage électromagnétique hermétiquement clos ;
une bague métallique (401) est disposée sur une partie de contact entre le module de circuit imprimé (104, 201, 202, 301, 302) et le capuchon (103, 203, 303) d'électrode négative, des fentes de serrage (305, 402) sont prévues à l'intérieur de la bague métallique (401), et la bague métallique est en contact conducteur avec les fentes de serrage, de manière à former un espace de blindage électromagnétique hermétiquement clos avec le capuchon d'électrode négative ; et
la rondelle isolante (106, 207) a une section en forme de " 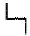 ", et est disposée dans des interstices dans l'enveloppe de pile, le module de circuit imprimé et le capuchon d'électrode négative, de manière à comprimer et fixer le module de circuit imprimé entre la structure de ligne circulaire en retrait (107, 205) et l'enveloppe (101, 206) de pile, et à isoler l'enveloppe de pile du capuchon d'électrode négative,
des saillies de serrage (306) correspondant aux fentes de serrage (305, 402) étant prévues sur le bord du capuchon d'électrode négative pour fixer le capuchon d'électrode négative sur le module de circuit imprimé.

2. Pile électrochimique secondaire (100, 200) selon la revendication 1, où le capuchon (103, 203, 303) d'électrode négative est en matériau électriquement conducteur.

3. Pile électrochimique secondaire (100, 200) selon la revendication 1, où la rondelle isolante (106, 207) est une couche de rembourrage annulaire flexible et élastique.

4. Pile électrochimique secondaire (100, 200) selon la revendication 1, où un segment de la rondelle isolante (106, 207) en forme de 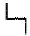 sert à comprimer et fixer le module de circuit imprimé entre la structure de ligne circulaire en retrait (107, 205) et l'enveloppe (101, 206) de pile, et l'autre segment sert pour isoler l'enveloppe de pile du capuchon d'électrode négative.
